# EUROPEAN PATENT APPLICATION

(11) **EP 4 738 436 A1**
(43) Date of publication of application: **06.05.2026**
(21) Application number: 25151094.7
(22) Date of filing: 10.01.2025
(51) Int. Cl.: H01L 23/373

(54) **POWER MODULE**

(30) Priority: 01.11.2024 TW 113141946
(71) Applicant: Actron Technology Corporation, Taoyuan City 338 (TW)
(72) Inventor: TSAI, Hsin-Chang, 338 Taoyuan City (TW); LIU, Ching-Wen, 338 Taoyuan City (TW)
(74) Representative: Melchior, Robin

(57) **Abstract**

A power module includes a heat dissipation substrate (10), a carrier (12), a connection substrate (20), a power transistor chip group (36), several conductive members (40), several external connection leads (46), and a package (48) packaging the aforementioned components. The carrier (12) is disposed on the heat dissipation substrate (10) and includes an insulation plate (14) and a patterned metal circuit layer (16). The connection substrate (20) is disposed on the patterned metal circuit layer (16) and includes a multilayered metallic connection structure (24). The power transistor chip group (36) is disposed on the connection substrate (20) and includes several power transistor chips (38) electrically connected to one another through the multilayered metallic connection structure (24). The conductive members (40) are electrically connected to the patterned metal circuit layer (16). The external connection leads (46) are disposed on the patterned metal circuit layer (16).

## Description

### BACKGROUND

### Technical Field

The present invention relates generally to a packaging structure of a power transistor, and more particularly to a power module with a connection substrate.

### Description of Related Art

A conventional power module includes a carrier, a plurality of power transistor chips, a lead frame, and a package. The carrier has a patterned metal circuit layer. The power transistor chips are disposed on the patterned metal circuit layer. The power transistor chips are electrically connected to one another by wire bonding and are electrically connected to one another through the patterned metal circuit layer. The lead frame is disposed on the patterned metal circuit layer and is electrically connected to the power transistor chips. The package packages the carrier, the power transistor chips, and the lead frame.

As the power transistor chips are electrically connected to one another by wire bonding, a distance has to be maintained between two adjacent power transistor chips for accommodating a bent wire. When the distance is too short, the wire is excessively bent and hence bonding could not be properly performed. A space for accommodating the wire is reserved. Therefore, if the number of power transistor chips is increased to improve the power density of the power module, a carrier with a larger area is required to carry more power transistor chips, which increases a size of the power module. Moreover, an increase of the number of wires causes difficulty in bonding, and the complexity of the patterned metal circuit layer affects the heat dissipation efficiency.

Therefore, the conventional power module still has room for improvement.

### SUMMARY OF THE INVENTION

In view of the above, the primary objective of the present invention is to provide a power module, which could reduce a number of conductive members used and reduce a complexity of a patterned metal circuit layer.

The present invention provides a power module, including a heat dissipation substrate, a carrier, at least one connection substrate, at least one power transistor chip group, a plurality of conductive members, a plurality of external connection leads, and a package. The heat dissipation substrate has a top surface and a bottom surface. The carrier is disposed on the top surface of the heat dissipation substrate. The carrier includes an insulation plate and a patterned metal circuit layer. The insulation plate has a top surface. The patterned metal circuit layer is disposed on the top surface of the insulation plate. The at least one connection substrate is disposed on the patterned metal circuit layer of the insulation plate. The at least one connection substrate includes a built-in package and a multilayered metallic connection structure. The multilayered metallic connection structure is embedded in the built-in package. The at least one power transistor chip group includes a plurality of power transistor chips. The at least one power transistor chip group is disposed on the at least one connection substrate. The plurality of power transistor chips are electrically connected to one another through the multilayered metallic connection structure. The plurality of conductive members are electrically connected to the patterned metal circuit layer of the carrier and the at least one power transistor chip group. The plurality of external connection leads are disposed on the patterned metal circuit layer of the carrier. The plurality of external connection leads are electrically connected to the at least one power transistor chip group. The package packages the heat dissipation substrate, the carrier, the at least one connection substrate, the at least one power transistor chip group, and the plurality of external connection leads. The package has a bottom opening. At least a part of the bottom surface of the heat dissipation substrate is exposed in the bottom opening.

With the aforementioned design, the power transistor chips of the at least one power transistor chip group are electrically connected to one another through the multilayered metallic connection structure of the at least one connection substrate, so that the number of the conductive members for connecting the power transistor chips could be reduced and hence more power transistor chips could be disposed. Moreover, the complexity of the patterned metal circuit layer of the carrier could be reduced, thereby improving the heat dissipation efficiency.

### BRIEF DESCRIPTION OF THE DRAWINGS

The present invention will be best understood by referring to the following detailed description of some illustrative embodiments in conjunction with the accompanying drawings, in which
FIG. 1 is a perspective view of the power module according to a first embodiment of the present invention;
FIG. 2 is a perspective view of the power module according to the first embodiment of the present invention seen from another perspective;
FIG. 3 is a perspective view of the power module according to the first embodiment of the present invention, wherein the package is hidden;
FIG. 4 is a partially enlarged view of FIG. 3;
FIG. 5 is a sectional schematic view of the power module according to the first embodiment of the present invention;
FIG. 6 is a partially exploded view of the connection substrate and the power transistor chips according to the first embodiment of the present invention;
FIG. 7 is a partially exploded view of the connection substrate according to the first embodiment of the present invention;
FIG. 8 is a perspective view of the power module according to the first embodiment of the present invention, showing that the connection substrate is disposed on the carrier;
FIG. 9 is a top view of the carrier according to the first embodiment of the present invention;
FIG. 10 is a perspective view of the power module according to the first embodiment of the present invention, showing that the carrier is disposed on the heat dissipation substrate; and
FIG. 11 is a sectional schematic view of the power module according to a second embodiment of the present invention.

### DETAILED DESCRIPTION OF THE INVENTION

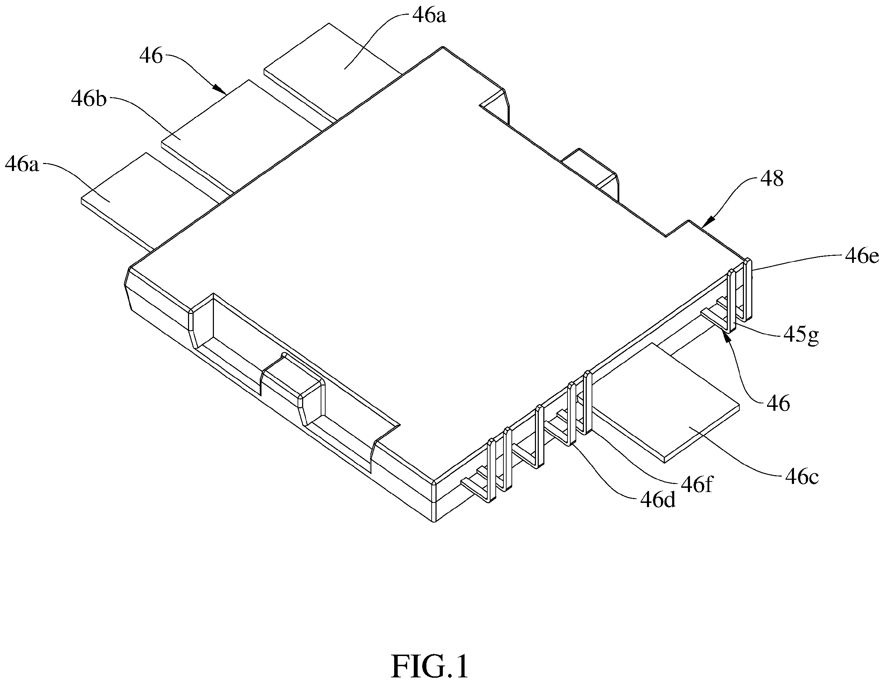

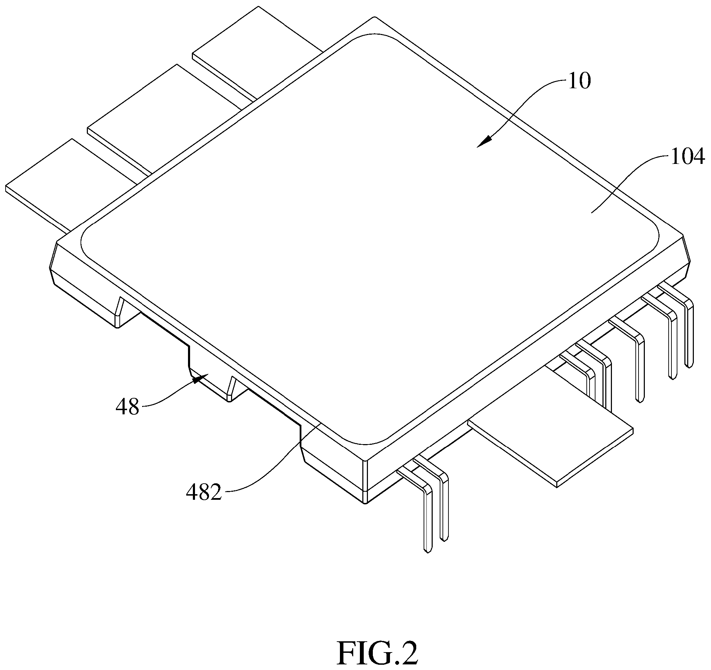

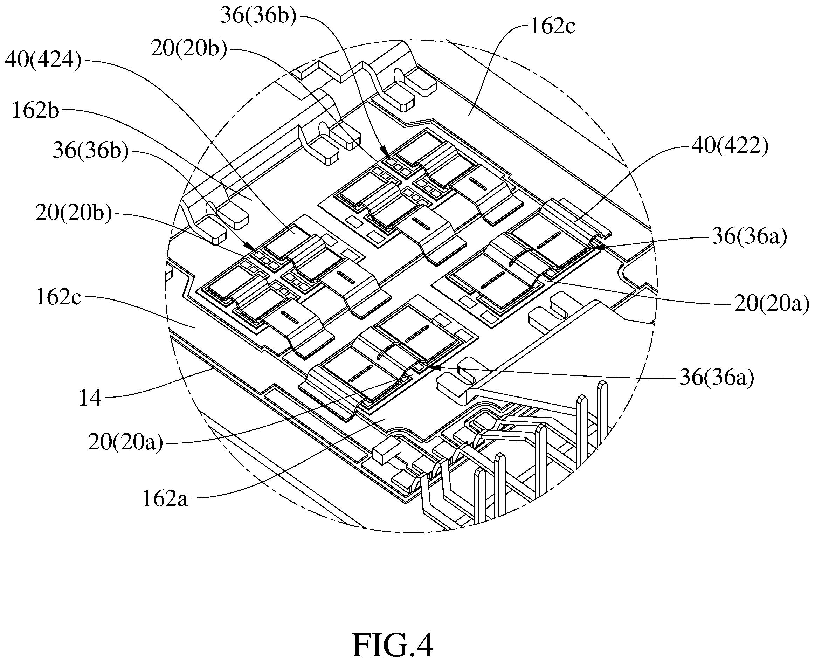

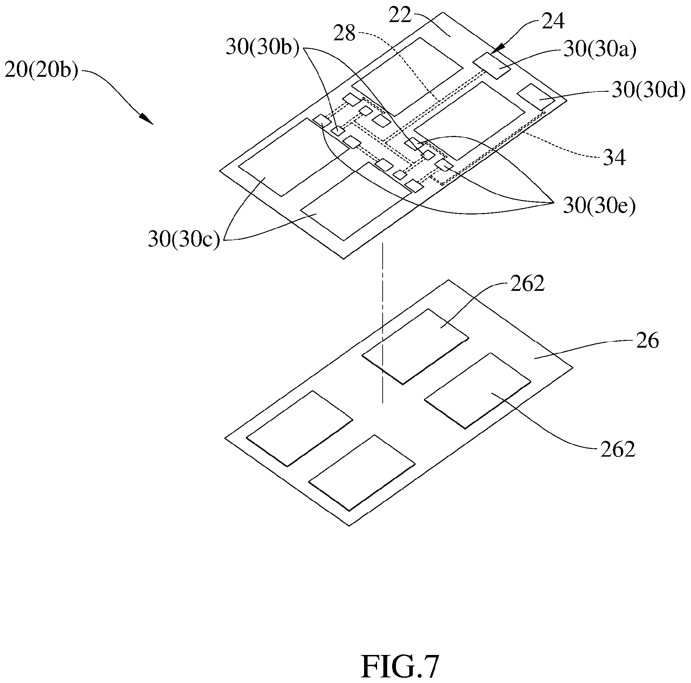

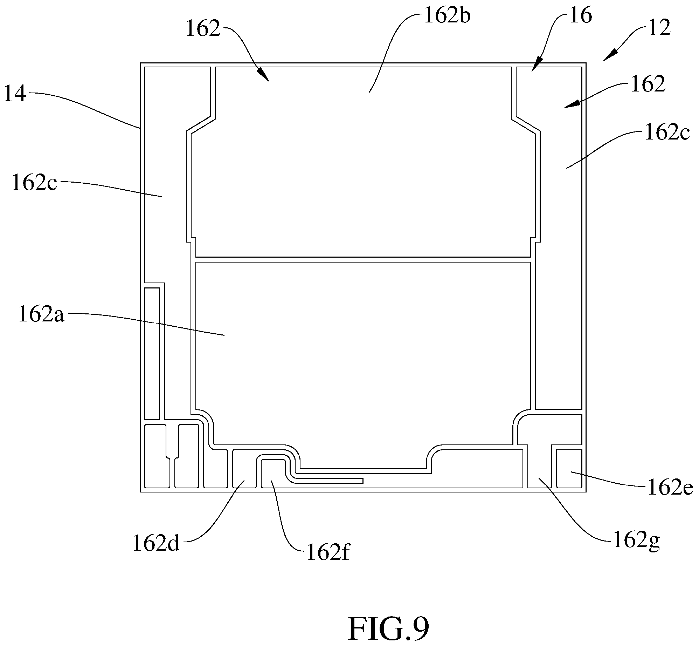

A power module according to a first embodiment of the present invention is illustrated in FIG. 1 to FIG. 11 and includes a heat dissipation substrate 10, a carrier 12, at least one connection substrate 20, at least one power transistor chip group 36, a plurality of conductive members 40, a plurality of external connection leads 46, and a package 48.

The heat dissipation substrate 10 has a top surface 102 and a bottom surface 104. The heat dissipation substrate 10 could be made of metal, compound including metal, or graphite, but not limited thereto. The metal could be, for example, copper or aluminum. The compound including metal could be, for example, aluminum silicon carbide (AlSiC).

The carrier 12 is disposed on the top surface 102 of the heat dissipation substrate 10. The carrier 12 includes an insulation plate 14 and a patterned metal circuit layer 16. The insulation plate 14 has a top surface 142 and a bottom surface 144. The patterned metal circuit layer 16 is disposed on the top surface 142 of the insulation plate 14. In the current embodiment, the carrier 12 further includes a bottom metallic layer 18, wherein the bottom metallic layer 18 is disposed on the bottom surface 144 of the insulation plate 14, and the bottom metallic layer 18 and the patterned metal circuit layer 16 are electrically isolated from each other. The carrier 12 could be made by, for example, active metal brazing (AMB) or direct bonding copper (DBC). The carrier 12 is connected to the top surface 102 of the heat dissipation substrate 10 through the bottom metallic layer 18 to be disposed on the top surface 102 of the heat dissipation substrate 10. For example, the bottom metallic layer 18 of the carrier 12 could be connected to the top surface 102 of the heat dissipation substrate 10 by welding. In this way, both the bottom metallic layer 18 and the heat dissipation substrate 10 are electrically isolated from the patterned metal circuit layer 16.

The patterned metal circuit layer 16 of the carrier 12 includes a plurality of conductive portions 162. One of the conductive portions 162 is a high-side conductive portion 162a. Another one of the conductive portions 162 is a low-side conductive portion 162b. Both an area of the high-side conductive portion 162a and an area of the low-side conductive portion 162b are greater than an area of the others of the conductive portions 162. The conductive portions 162 further include at least one power conductive portion 162c. The at least one power conductive portion 162c is located on at least one side of the high-side conductive portion 162a and at least one side of the low-side conductive portion 162b. In the current embodiment, the at least one power conductive portion 162c includes two power conductive portions 162c, wherein the two power conductive portions 162c are located on two opposite sides of the high-side conductive portion 162a and two opposite sides of the low-side conductive portion 162b.

The conductive portions 162 further include a high-side control conductive portion 162d, a low-side control conductive portion 162e, and a plurality of detection conductive portions 162f,162g.

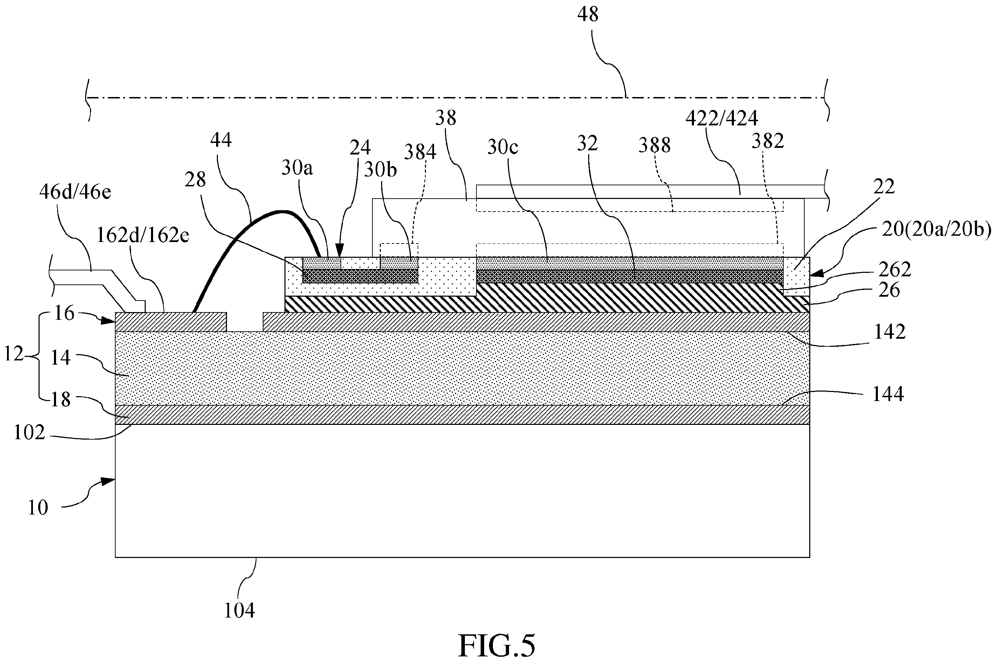

In the current embodiment, the at least one connection substrate 20 includes a plurality of connection substrates 20, wherein the connection substrates 20 are disposed on the patterned metal circuit layer 16 of the insulation plate 14. The connection substrates 20 are structurally identical to one another. In order to illustrate easily, one of the connection substrates 20 is used for illustration. Referring to FIG. 5 to FIG. 7, the connection substrate 20 includes a built-in package 22 and a multilayered metallic connection structure 24. The multilayered metallic connection structure 24 is embedded in the built-in package 22. In the current embodiment, the built-in package 22 is a polymer, such as epoxy resin. The multilayered metallic connection structure 24 includes a metallic support layer 26, an internal circuit 28, and a plurality of top pads 30. The metallic support layer 26 is located on a bottom of the built-in package 22, wherein a bottom surface of the metallic support layer 26 is not covered by the built-in package 22. The internal circuit 28 is located in an inner portion of the built-in package 22. The top pads 30 are located on a top of the built-in package 22, wherein a top surface of the top pads 30 is not covered by the built-in package 22. The multilayered metallic connection structure 24 forms a three-dimensional connection structure.

The metallic support layer 26 has a plurality of protruding platforms 262. The multilayered metallic connection structure 24 further includes a plurality of internal pads 32. The internal pads 32 are connected to the protruding platforms 262. The internal pads 32 and the internal circuit 28 are located on an identical layer. The top pads 30 include a first top pad 30a, a plurality of second top pads 30b, and a plurality of third top pads 30c. The first top pad 30a and each of the second top pads 30b are connected to the internal circuit 28. Each of the third top pads 30c is connected to each of the internal pads 32. In this way, the first top pad 30a could be electrically connected to the second top pads 30b through the internal circuit 28, and each of the third top pads 30c is electrically connected to the metallic support layer 26 through each of the internal pads 32. The connection substrate 20 is connected to the patterned metal circuit layer 16 of the carrier 12 through the metallic support layer 26 to be disposed on the patterned metal circuit layer 16. For example, the metallic support layer 26 of the connection substrate 20 could be connected to the patterned metal circuit layer 16 of the carrier 12 by welding.

The multilayered metallic connection structure 24 further includes another internal circuit 34. The top pads 30 further include a fourth top pad 30d and a plurality of fifth top pads 30e. The another internal circuit 34 and the internal circuit 28 are located on an identical layer. The fourth top pad 30d could be electrically connected to the fifth top pads 30e through the another internal circuit 34.

More specifically, the connection substrates 20 include at least one high-side connection substrate 20a and at least one low-side connection substrate 20b. In the current embodiment, the at least one high-side connection substrate 20a includes a plurality of high-side connection substrates 20a, such as two high-side connection substrates 20a; the at least one low-side connection substrate 20b includes a plurality of low-side connection substrates 20b, such as two low-side connection substrates 20b. The high-side connection substrates 20a are disposed on the high-side conductive portion 162a of the patterned metal circuit layer 16. The low-side connection substrates 20b are disposed on the low-side conductive portion 162b of the patterned metal circuit layer 16.

The at least one power transistor chip group 36 includes a plurality of power transistor chips 38. Each of the power transistor chips 38 is a MOSFET, such as a SiC MOSFET, but not limited thereto. Each of the power transistor chips 38 could also be a BJT or an IGBT. In the current embodiment, the at least one power transistor chip group 36 includes a plurality of power transistor chip groups 36; each of the power transistor chip groups 36 is disposed on each of the connection substrates 20; each of the power transistor chip groups 36 is disposed on each of the connection substrates 20 by, for example, flip chip. The power transistor chips 38 of each of the power transistor chip groups 36 are electrically connected to the multilayered metallic connection structure 24 of each of the connection substrates 20. Moreover, each of the power transistor chips 38 of each of the power transistor chip groups 36 is electrically connected to the patterned metal circuit layer 16 of the carrier 12 through the multilayered metallic connection structure 24 of one of the connection substrates 20 that is corresponding.

More specifically, the power transistor chip groups 36 include at least one high-side power transistor chip group 36a and at least one low-side power transistor chip group 36b. In the current embodiment, the at least one high-side power transistor chip group 36a includes a plurality of high-side power transistor chip groups 36a, such as two high-side power transistor chip groups 36a; each of the high-side power transistor chip groups 36a includes a plurality of power transistor chips 38, such as four power transistor chips 38; the at least one low-side power transistor chip group 36b includes a plurality of low-side power transistor chip groups 36b, such as two low-side power transistor chip groups 36b; each of the low-side power transistor chip groups 36b includes a plurality of power transistor chips 38, such as four power transistor chips 38. Each of the high-side power transistor chip groups 36a is disposed on each of the high-side connection substrates 20a. Each of the low-side power transistor chip groups 36b is disposed on each of the low-side connection substrates 20b.

A power connection electrode 382 (source) of each of the power transistor chips 38 of each of the high-side power transistor chip groups 36a is connected to each of the third top pads 30c of each of the high-side connection substrates 20a. For example, the power connection electrode 382 (source) of each of the power transistor chips 38 of each of the high-side power transistor chip groups 36a is connected to each of the third top pads 30c of each of the high-side connection substrates 20a by welding. In this way, each of the high-side power transistor chip groups 36a is electrically connected to the high-side conductive portion 162a through the metallic support layer 26 of each of the high-side connection substrates 20a. A power connection electrode 382 (source) of each of the power transistor chips 38 of each of the low-side power transistor chip groups 36b is connected to each of the third top pads 30c of each of the low-side connection substrates 20b. For example, the power connection electrode 382 (source) of each of the power transistor chips 38 of each of the low-side power transistor chip groups 36b is connected to each of the third top pads 30c of each of the low-side connection substrates 20b by welding. In this way, each of the low-side power transistor chip groups 36b is electrically connected to the low-side conductive portion 162b through the metallic support layer 26 of each of the low-side connection substrates 20b.

As both the area of the high-side conductive portion 162a and the area of the low-side conductive portion 162b of the conductive portions 162 of the patterned metal circuit layer 16 of the carrier 12 are greater than the area of the others of the conductive portions 162, a heat generated by the high-side power transistor chip groups 36a and a heat generated by the low-side power transistor chip groups 36b could be dissipated to the high-side conductive portion 162a and the low-side conductive portion 162b, respectively, thereby achieving a good heat dissipation effect.

A control electrode 384 (gate) of each of the power transistor chips 38 of each of the high-side power transistor chip groups 36a is connected to each of the second top pads 30b of each of the high-side connection substrate 20a. For example, the control electrode 384 (gate) of each of the power transistor chips 38 of each of the high-side power transistor chip groups 36a is connected to each of the second top pads 30b of each of the high-side connection substrate 20a by welding. A control electrode 384 (gate) of each of the power transistor chips 38 of each of the low-side power transistor chip groups 36b is connected to each of the second top pads 30b of each of the low-side connection substrates 20b. For example, the control electrode 384 (gate) of each of the power transistor chips 38 of each of the low-side power transistor chip groups 36b is connected to each of the second top pads 30b of each of the low-side connection substrates 20b by welding. In other words, the control electrode 384 of the power transistor chips 38 of each of the power transistor chip groups 36 is jointly and electrically connected to the first top pad 30a of each of the connection substrates 20.

A plurality of detection electrodes 386 of each of the power transistor chips 38 of each of the high-side power transistor chip groups 36a are respectively connected to the fifth top pads 30e of each of the high-side connection substrates 20a. For example, the detection electrodes 386 of each of the power transistor chips 38 of each of the high-side power transistor chip groups 36a are respectively connected to the fifth top pads 30e of each of the high-side connection substrates 20a by welding. In this way, the detection electrodes 386 of each of the power transistor chips 38 of each of the high-side power transistor chip groups 36a are jointly and electrically connected to the fourth top pad 30d of each of the high-side connection substrates 20a. A plurality of detection electrodes 386 of each of the power transistor chips 38 of each of the low-side power transistor chip groups 36b are respectively connected to the fifth top pads 30e of each of the low-side connection substrates 20b. For example, the detection electrodes 386 of each of the power transistor chips 38 of each of the low-side power transistor chip groups 36b are respectively connected to the fifth top pads 30e of each of the low-side connection substrates 20b by welding. In this way, the detection electrodes 386 of each of the power transistor chips 38 of each of the low-side power transistor chip groups 36b are jointly and electrically connected to the fourth top pad 30d each of the low-side connection substrates 20b.

The conductive members 40 are electrically connected to the patterned metal circuit layer 16 of the carrier 12 and the power transistor chip groups 36. More specifically, each of the conductive members 40 could be, for example, a metallic bridge member or a metal wire. The conductive members 40 includes at least one first conductive member, a second conductive member, and a plurality of third conductive members. For example, the at least one first conductive member includes at least one first metallic bridge member 422; the second conductive member includes at least one second metallic bridge member 424; the third conductive members include a plurality of metal wires 44. In the current embodiment, the at least one first metallic bridge member 422 includes a plurality of first metallic bridge members 422, such as two first metallic bridge members 422; the at least one second metallic bridge member 424 includes a plurality of second metallic bridge members 424, such as four second metallic bridge members 424. Each of the power conductive portions 162c is connected to another power connection electrode 388 (drain) of each of the power transistor chips 38 of each of the high-side power transistor chip groups 36a through each of the first metallic bridge members 422. For example, each of the power conductive portions 162c is connected to the another power connection electrode 388 (drain) of each of the power transistor chips 38 of each of the high-side power transistor chip groups 36a through each of the first metallic bridge members 422 by welding. The high-side conductive portion 162a is connected to another power connection electrode 388 (drain) of each of the power transistor chips 38 of each of the low-side power transistor chip groups 36b through at least one of the second metallic bridge members 424. For example, the high-side conductive portion 162a is connected to the another power connection electrode 388 (drain) of each of the power transistor chips 38 of each of the low-side power transistor chip groups 36b through at least one of the second metallic bridge members 424 by welding. In the current embodiment, the high-side conductive portion 162a is connected to the another power connection electrode 388 of each of the power transistor chips 38 of each of the low-side power transistor chip groups 36b through two of the second metallic bridge members 424. An extension direction of each of the first metallic bridge members 422 is perpendicular to an extension direction of each of the second metallic bridge members 424, thereby utilizing space in an efficient manner and simplifying an arrangement of the metallic bridge members. Moreover, using the metallic bridge members for connections could reduce parasitic inductance. In an embodiment, each of the first conductive members and each of the second conductive members could be a metal wire.

An inner end of the external connection leads 46 is disposed on the patterned metal circuit layer 16 of the carrier 12. An outer end of the external connection leads 46 laterally extends to an outer side of the package 48. The external connection leads 46 are electrically connected to the power transistor chip groups 36. The external connection leads 46 include at least one power lead 46a, a ground lead 46b, and an output lead 46c. In the current embodiment, the at least one power lead 46a includes two power leads 46a; an inner end of each of the power leads 46a is disposed on each of the power conductive portions 162c of the patterned metal circuit layer 16; each of the two power leads 46a is configured to connect to a positive terminal of a power source (not shown). An inner end of the ground lead 46b is disposed on the low-side conductive portion 162b of the patterned metal circuit layer 16. The ground lead 46b is configured to connect to a negative terminal of the power source. An inner end of the output lead 46c is disposed on the high-side conductive portion 162a of the patterned metal circuit layer 16. The output lead 46c is configured to connect to a load (such as a motor; not shown).

The metallic support layer 26 of each of the connection substrates 20 and are electrically connected to at least one of the external connection leads 46 through the patterned metal circuit layer 16. In other words, the metallic support layer 26 of each of the high-side connection substrates 20a is electrically connected to the output lead 46c through the high-side conductive portion 162a. The metallic support layer 26 of each of the low-side connection substrates 20b is electrically connected to the ground lead 46b through the low-side conductive portion 162b.

The external connection leads 46 further include a high-side control lead 46d and a low-side control lead 46e. In the current embodiment, an inner end of the high-side control lead 46d is disposed on the high-side control conductive portion 162d of the patterned metal circuit layer 16; the high-side control lead 46d is configured to connect to a high-side control terminal of a control device (not shown) to receive a high-side control signal from the high-side control terminal.

Referring to FIG. 5, the high-side control conductive portion 162d is connected to the first top pad 30a of one of the high-side connection substrates 20a through at least one of the metal wires 44. In this way, the high-side control signal could be sent to the control electrode 384 of each of the power transistor chips 38 of each of the high-side power transistor chip groups 36a through the multilayered metallic connection structure 24 of each of the high-side connection substrates 20a.

Referring to FIG. 5, an inner end of the low-side control lead 46e is disposed on the low-side control conductive portion 162e of the patterned metal circuit layer 16. The low-side control lead 46e is configured to connect to a low-side control terminal of the control device to receive a low-side control signal from the low-side control terminal. The low-side control conductive portion 162e is connected to the first top pad 30a of the low-side connection substrate 20b through at least one of the metal wires 44. In this way, the low-side control signal could be sent to the control electrode 384 of each of the power transistor chips 38 of each of the low-side power transistor chip groups 36b through the multilayered metallic connection structure 24 of each of the low-side connection substrates 20b.

In an embodiment, the high-side control conductive portion 162d could be electrically connected to the first top pad 30a of the high-side connection substrate 20a through a bridge circuit. The bridge circuit is formed by connecting one of the third conductive members, a conductive portion 162, and another one of the third conductive members in sequence. Similarly, the low-side control conductive portion 162e could be connected to the first top pad 30a of the low-side connection substrate 20b through another bridge circuit.

The external connection leads 46 further include a plurality of detection leads. The detection leads include a high-side detection lead 46f and a low-side detection lead 46g. An inner end of the high-side detection lead 46f is disposed on the detection conductive portion 162f, and the detection conductive portion 162f is connected to the two fourth top pads 30d of the two high-side connection substrates 20a through two of the third conductive members (not shown), respectively. An inner end of the low-side detection lead 46g is disposed on the detection conductive portion 162g, and the detection conductive portion 162g is connected to the two fourth top pads 30d of the two low-side connection substrates 20b through two of the third conductive members (not shown), respectively. In this way, an electrical property of the high-side power transistor chip groups 36a and an electrical property of the low-side power transistor chip groups 36b could be detected by the detection leads.

The package 48 packages the heat dissipation substrate 10, the carrier 12, the connection substrates 20, the power transistor chip groups 36, and the external connection leads 46. The package 48 has a bottom opening 482. At least a part of the bottom surface 104 of the heat dissipation substrate 10 is exposed in the bottom opening 482 and is not covered by the package 48. The heat generated by each of the power transistor chip groups 36 is conducted to the carrier 12 and then is conducted from the carrier 12 to the heat dissipation substrate 10. Finally, the heat is dissipated to an external environment through the bottom surface 104 of the heat dissipation substrate 10. A part of the external connection leads 46 extends out of the package 48. In the current embodiment, the package 48 is made of polymer, such as epoxy resin.

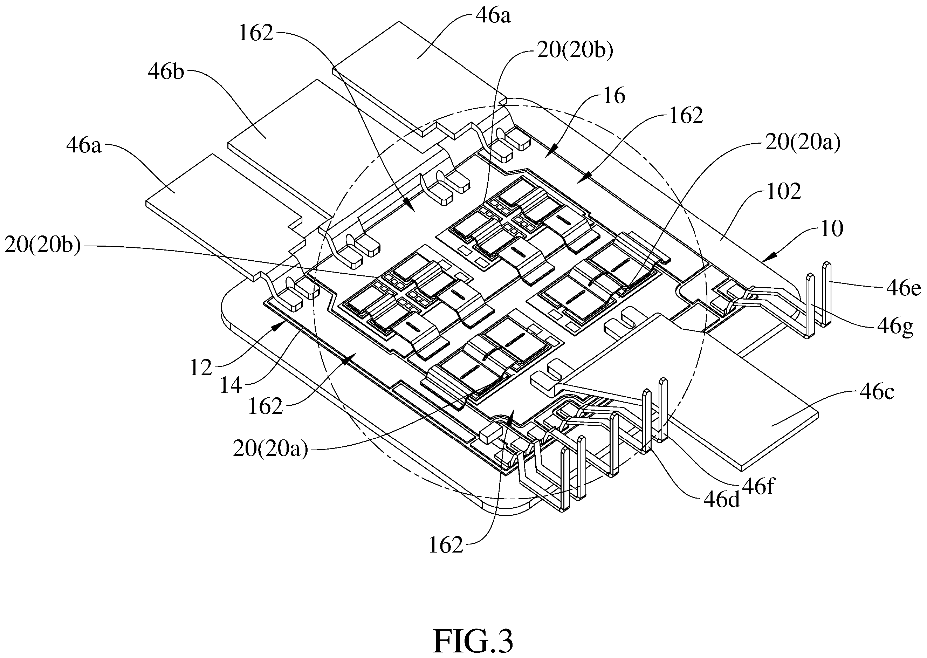

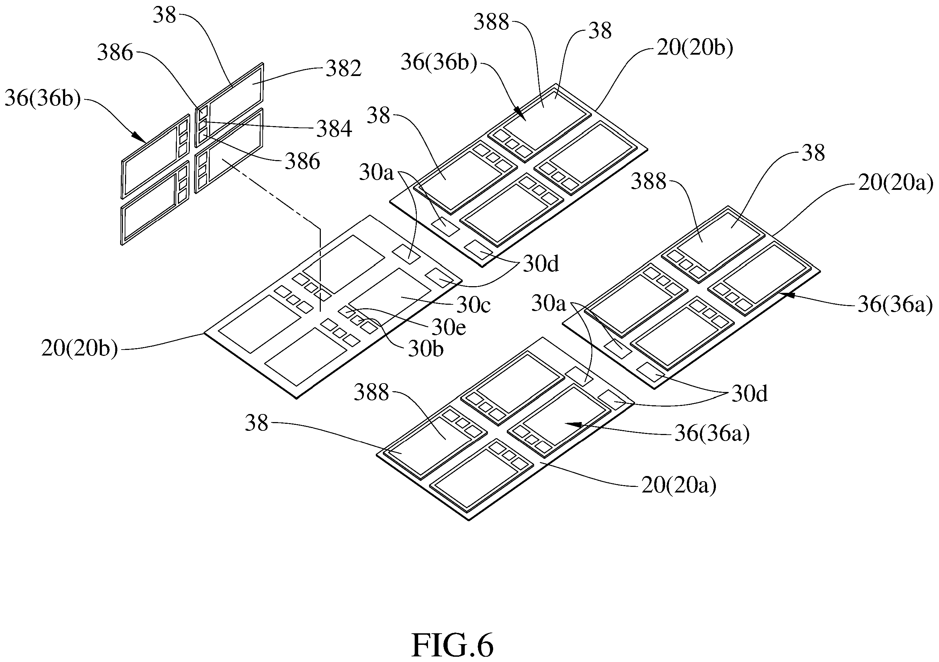

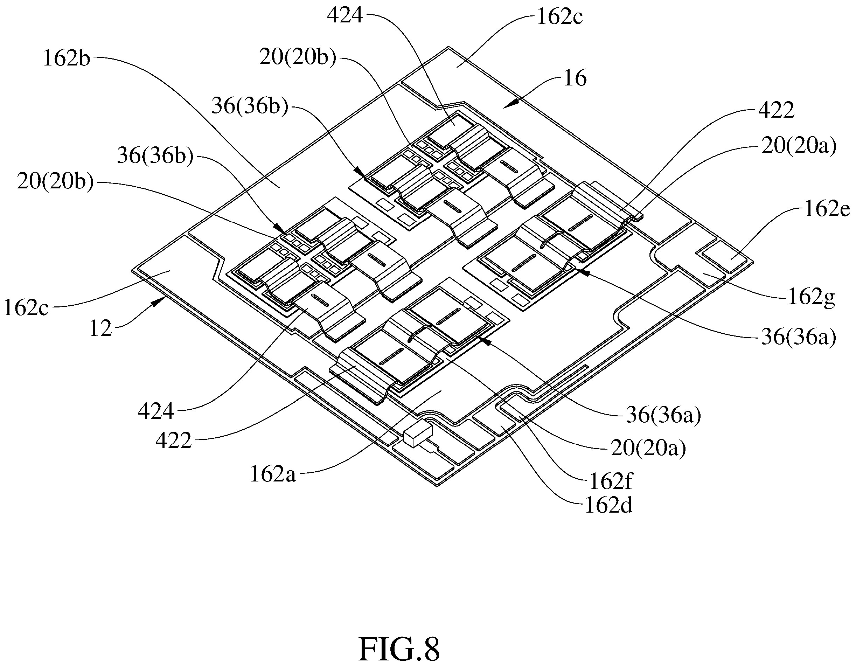

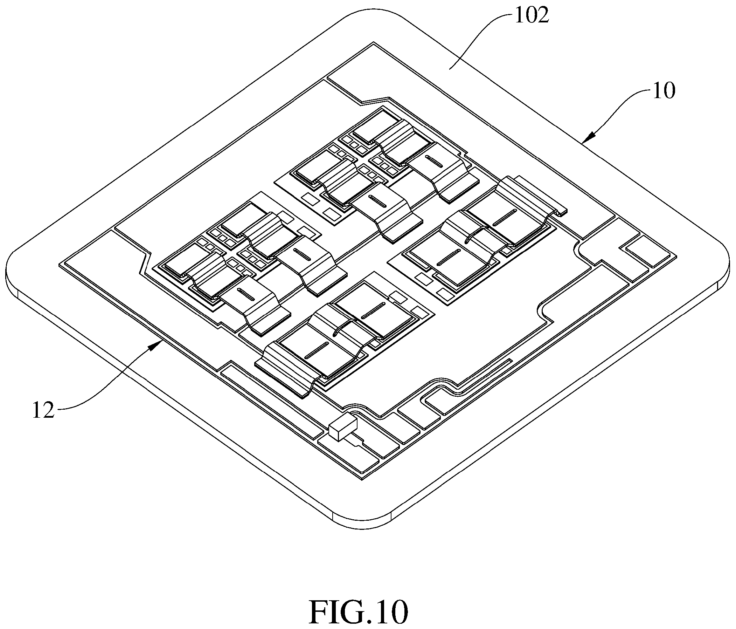

A process of assembling the power module includes step A to step F:
Step A: referring to FIG. 6, dispose each of the power transistor chip groups 36 on each of the connection substrates 20;
Step B: referring to FIG. 8, dispose each of the connection substrates 20 on the patterned metal circuit layer 16 of the carrier 12, and correspondingly connect the first metallic bridge members 422 and the second metallic bridge members 424 of the conductive members 40 to the power transistor chips 38 of the power transistor chip groups 36 and the conductive portions 162 of the patterned metal circuit layer 16;
Step C: correspondingly connect the metal wires 44 to the conductive portions 162 and the connection substrates 20;
Step D: referring to FIG. 10, dispose the carrier 12 on the heat dissipation substrate 10;
Step E: referring to FIG. 3, dispose the external connection leads 46 on the conductive portions 162 of the patterned metal circuit layer 16; and
Step F: referring to FIG. 1, package, with the package 48, the heat dissipation substrate 10, the carrier 12, the connection substrates 20, the power transistor chip groups 36, and the external connection leads 46.

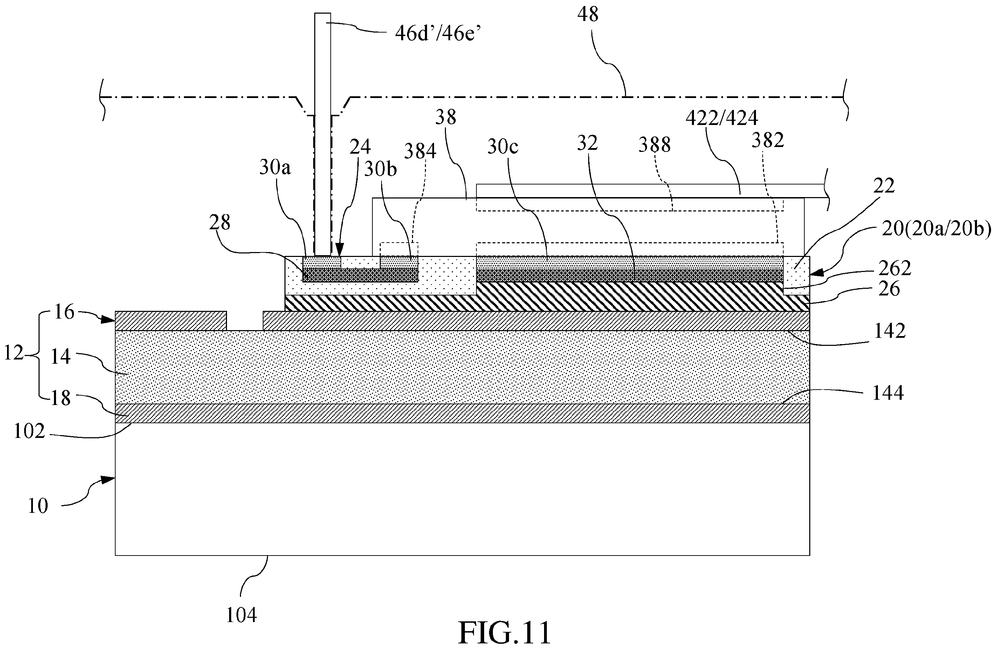

A power module according to a second embodiment of the present invention is illustrated in FIG. 11 and has a structure almost identical to that of the first embodiment, except that in the second embodiment, at least a part of the external connection leads 46 (such as a high-side control lead 46d' and a low-side control lead 46e') is a metallic conductive post, such as a copper post. The high-side control lead 46d' and the low-side control lead 46e' are vertically disposed on the high-side control conductive portion 162d and the low-side control conductive portion 162e, respectively. An inner end of the high-side control lead 46d' is directly connected to the high-side control conductive portion 162d. An inner end of the low-side control lead 46e' is directly connected to the low-side control conductive portion 162e. An outer end of the high-side control lead 46d' and an outer end of the low-side control lead 46e extend out of the package 48 to connect to the control device.

In summary, the power transistor chips 38 of the same power transistor chip group 36 of the power module are electrically connected to one another through the multilayered metallic connection structure 24 of one of the connection substrates 20. In this way, the number of the conductive members 40 for connecting the same power transistor chip group 36 could be reduced. Especially when the number of the power transistor chips 38 is increased, the number of the conductive members 40 that the present invention could avoid is increased. Moreover, the connection substrate 20 could improve the flexibility of design and reduce the complexity of the patterned metal circuit layer 16 of the carrier 12. The area of the conductive portions 162 (the high-side conductive portion 162a and the low-side conductive portion 162b) located below the connection substrates 20 is increased, thereby improving the heat dissipation efficiency and reducing the structural thermal resistance. As the number of the conductive members 40 could be reduced and the complexity of the patterned metal circuit layer 16 of the carrier 12 could be reduced, the number of the power transistor chips 38 disposed on the carrier 12 could be increased, thereby increasing a power efficiency that the power module could withstand. Additionally, the heat dissipation substrate 10 located below the carrier 12 and the components located above the insulation plate 14 of the carrier 12 are completely electrically isolated from each other, so that the bottom surface 104 of the heat dissipation substrate 10 is only required to fulfill the heat dissipation need and does not require additional insulation means.

## Claims

1. A power module, comprising:
a heat dissipation substrate (10), having a top surface (102) and a bottom surface (104);
a carrier (12), disposed on the top surface (102) of the heat dissipation substrate (10) and comprising an insulation plate (14) and a patterned metal circuit layer (16), wherein the insulation plate (14) has a top surface (142); the patterned metal circuit layer (16) is disposed on the top surface (142) of the insulation plate (14);
at least one connection substrate (20), disposed on the patterned metal circuit layer (16) of the insulation plate (14) and comprising a built-in package (22) and a multilayered metallic connection structure (24), wherein the multilayered metallic connection structure (24) is embedded in the built-in package (22);
at least one power transistor chip group (36), comprising a plurality of power transistor chips (38), wherein the at least one power transistor chip group (36) is disposed on the at least one connection substrate (20); the plurality of power transistor chips (38) are electrically connected to one another through the multilayered metallic connection structure (24);
a plurality of conductive members (40), electrically connected to the patterned metal circuit layer (16) of the carrier (12) and the at least one power transistor chip group (36);
a plurality of external connection leads (46), disposed on the patterned metal circuit layer (16) of the carrier (12), wherein the plurality of external connection leads (46) are electrically connected to the at least one power transistor chip group (36); and
a package (48), packaging the heat dissipation substrate (10), the carrier (12), the at least one connection substrate (20), the at least one power transistor chip group (36), and the plurality of external connection leads (46), wherein the package (48) has a bottom opening (482); at least a part of the bottom surface (104) of the heat dissipation substrate (10) is exposed in the bottom opening (482).

2. The power module as claimed in claim 1, wherein the carrier (12) comprises a bottom metallic layer (18); the insulation plate (14) has a bottom surface (144); the bottom metallic layer (18) is disposed on the bottom surface (144) of the insulation plate (14); the bottom metallic layer (18) and the patterned metal circuit layer (16) are electrically isolated from each other; the bottom metallic layer (18) is connected to the top surface (102) of the heat dissipation substrate (10).

3. The power module as claimed in claim 1, wherein each of the plurality of power transistor chips (38) of the at least one power transistor chip group (36) is electrically connected to the patterned metal circuit layer (16) of the carrier (12) through the multilayered metallic connection structure (24).

4. The power module as claimed in claim 3, wherein the multilayered metallic connection structure (24) of the at least one connection substrate (20) comprises a metallic support layer (26); the metallic support layer (26) is located on a bottom of the built-in package (22); the metallic support layer (26) is connected to the patterned metal circuit layer (16) of the carrier (12) and is electrically connected to at least one of the plurality of external connection leads (46) through the patterned metal circuit layer (16).

5. The power module as claimed in claim 1, wherein the patterned metal circuit layer (16) of the carrier (12) comprises a plurality of conductive portions (162); one of the plurality of conductive portions (162) is a high-side conductive portion (162a), and another one of the plurality of conductive portions (162) is a low-side conductive portion (162b); both an area of the high-side conductive portion (162a) and an area of the low-side conductive portion (162b) are greater than an area of the others of the plurality of conductive portions (162); the at least one connection substrate (20) comprises a high-side connection substrate (20a) and a low-side connection substrate (20b); the high-side connection substrate (20a) is disposed on the high-side conductive portion (162a); the low-side connection substrate (20b) is disposed on the low-side conductive portion (162b); the at least one power transistor chip group (36) comprises a high-side power transistor chip group (36a) and a low-side power transistor chip group (36b); the high-side power transistor chip group (36a) is disposed on the high-side connection substrate (20a); the low-side power transistor chip group (36b) is disposed on the low-side connection substrate (20b).

6. The power module as claimed in claim 5, wherein both the multilayered metallic connection structure (24) of the high-side connection substrate (20a) and the multilayered metallic connection structure (24) of the low-side connection substrate (20b) comprise a metallic support layer (26); the metallic support layer (26) of the high-side connection substrate (20a) is located on a bottom of the built-in package (22) of the high-side connection substrate (20a), and the metallic support layer (26) of the low-side connection substrate (20b) is located on a bottom of the built-in package (22) of the low-side connection substrate (20b); the high-side power transistor chip group (36a) is electrically connected to the high-side conductive portion (162a) through the metallic support layer (26) of the high-side connection substrate (20a); the low-side power transistor chip group (36b) is electrically connected to the low-side conductive portion (162b) through the metallic support layer (26) of the low-side connection substrate (20b).

7. The power module as claimed in claim 6, wherein the plurality of conductive portions (162) comprise a power conductive portion (162c); the plurality of external connection leads (46) comprise a power lead (46a), a ground lead (46b), and an output lead (46c); an inner end of the power lead (46a) is disposed on the power conductive portion (162c); an inner end of the ground lead (46b) is disposed on the low-side conductive portion (162b); an inner end of the output lead (46c) is disposed on the high-side conductive portion (162a).

8. The power module as claimed in claim 7, wherein the plurality of conductive members (40) comprise at least one first conductive member and at least one second conductive member; the power conductive portion (162c) is connected to a power connection electrode (388) of each of the plurality of power transistor chips (38) of the high-side power transistor chip group (36a) through the at least one first conductive member; the high-side conductive portion (162a) is connected to a power connection electrode (388) of each of the plurality of power transistor chips (38) of the low-side power transistor chip group (36b) through the at least one second conductive member.

9. The power module as claimed in claim 8, wherein the power conductive portion (162c) is located on a side of the high-side conductive portion (162a) and a side of the low-side conductive portion (162b); an extension direction of the at least one first conductive member is perpendicular to an extension direction of the at least one second conductive member.

10. The power module as claimed in claim 8, wherein the at least one first conductive member is at least one first metallic bridge member (422); the at least one second conductive member is at least one second metallic bridge member (424).

11. The power module as claimed in claim 8, wherein both the multilayered metallic connection structure (24) of the high-side connection substrate (20a) and the multilayered metallic connection structure (24) of the low-side connection substrate (20b) include a first top pad (30a), a plurality of second top pads (30b), and an internal circuit (28); the first top pad (30a) and the plurality of second top pads (30b) of the high-side connection substrate (20a) are located on a top of the built-in package (22) of the high-side connection substrate (20a); the first top pad (30a) and the plurality of second top pads (30b) of the low-side connection substrate (20b) are located on a top of the built-in package (22) of the low-side connection substrate (20b); the internal circuit (28) of the high-side connection substrate (20a) is located in an inner portion of the built-in package (22) of the high-side connection substrate (20a) and is connected to the first top pad (30a) and the plurality of second top pads (30b) of the high-side connection substrate (20a); the internal circuit (28) of the low-side connection substrate (20b) is located in an inner portion of the built-in package (22) of the low-side connection substrate (20b) and is connected to the first top pad (30a) and the plurality of second top pads (30b) of the low-side connection substrate (20b); the plurality of second top pads (30b) of the high-side connection substrate (20a) are respectively connected to a control electrode (384) of the plurality of power transistor chips (38) of the high-side power transistor chip group (36a); the plurality of second top pads (30b) of the low-side connection substrate (20b) are respectively connected to a control electrode (384) of the plurality of power transistor chips (38) of the low-side power transistor chip group (36b); the plurality of conductive portions (162) comprise a high-side control conductive portion (162d) and a low-side control conductive portion (162e); the plurality of external connection leads (46) comprise a high-side control lead (46d, 46d') and a low-side control lead (46e, 46e'); an inner end of the high-side control lead (46d, 46d') is disposed on the high-side control conductive portion (162d); an inner end of the low-side control lead (46e, 46e') is disposed on the low-side control conductive portion (162e); the plurality of conductive members (40) comprise a plurality of third conductive members; the high-side control conductive portion (162d) is connected to the first top pad (30a) of the high-side connection substrate (20a) through at least one of the plurality of third conductive members; the low-side control conductive portion (162e) is connected to the first top pad (30a) of the low-side connection substrate (20b) through at least one of the plurality of third conductive members.

12. The power module as claimed in claim 11, wherein the high-side control lead (46d') is a conductive post; the low-side control lead (46e') is a conductive post; the high-side control lead (46d') is vertically disposed on the high-side control conductive portion (162d); the low-side control lead (46e') is vertically disposed on the low-side control conductive portion (162e); the inner end of the high-side control lead (46d') is connected to the high-side control conductive portion (162d); the inner end of the low-side control lead (46e') is connected to the low-side control conductive portion (162e); both an outer end of the high-side control lead (46d') and an outer end of the low-side control lead (46e') extend out of the package (48).

13. The power module as claimed in claim 1, wherein the built-in package (22) of the at least one connection substrate (20) is a polymer.

## Amended claims

### Amended claims in accordance with Rule 137(2) EPC.

1. A power module, comprising:
a heat dissipation substrate (10), having a top surface (102) and a bottom surface (104);
a carrier (12), disposed on the top surface (102) of the heat dissipation substrate (10) and comprising an insulation plate (14) and a patterned metal circuit layer (16), wherein the insulation plate (14) has a top surface (142); the patterned metal circuit layer (16) is disposed on the top surface (142) of the insulation plate (14);
at least one connection substrate (20), disposed on the patterned metal circuit layer (16) of the insulation plate (14) and comprising a built-in package (22) and a multilayered metallic connection structure (24), wherein the multilayered metallic connection structure (24) is embedded in the built-in package (22);
at least one power transistor chip group (36), comprising a plurality of power transistor chips (38);
a plurality of conductive members (40), electrically connected to the patterned metal circuit layer (16) of the carrier (12) and the at least one power transistor chip group (36);
a plurality of external connection leads (46), disposed on the patterned metal circuit layer (16) of the carrier (12), wherein the plurality of external connection leads (46) are electrically connected to the at least one power transistor chip group (36); and
a package (48), packaging the heat dissipation substrate (10), the carrier (12), the at least one connection substrate (20), the at least one power transistor chip group (36), and the plurality of external connection leads (46), wherein the package (48) has a bottom opening (482); at least a part of the bottom surface (104) of the heat dissipation substrate (10) is exposed in the bottom opening (482);
**characterized in that**:
the at least one power transistor chip group (36) is disposed on the at least one connection substrate (20); the plurality of power transistor chips (38) are electrically connected to one another through the multilayered metallic connection structure (24);
each of the plurality of power transistor chips (38) of the at least one power transistor chip group (36) is electrically connected to the patterned metal circuit layer (16) of the carrier (12) through the multilayered metallic connection structure (24).

2. The power module as claimed in claim 1, wherein the carrier (12) comprises a bottom metallic layer (18); the insulation plate (14) has a bottom surface (144); the bottom metallic layer (18) is disposed on the bottom surface (144) of the insulation plate (14); the bottom metallic layer (18) and the patterned metal circuit layer (16) are electrically isolated from each other; the bottom metallic layer (18) is connected to the top surface (102) of the heat dissipation substrate (10).

3. The power module as claimed in claim 1, wherein the multilayered metallic connection structure (24) of the at least one connection substrate (20) comprises a metallic support layer (26); the metallic support layer (26) is located on a bottom of the built-in package (22); the metallic support layer (26) is connected to the patterned metal circuit layer (16) of the carrier (12) and is electrically connected to at least one of the plurality of external connection leads (46) through the patterned metal circuit layer (16).

4. The power module as claimed in claim 1, wherein the patterned metal circuit layer (16) of the carrier (12) comprises a plurality of conductive portions (162); one of the plurality of conductive portions (162) is a high-side conductive portion (162a), and another one of the plurality of conductive portions (162) is a low-side conductive portion (162b); both an area of the high-side conductive portion (162a) and an area of the low-side conductive portion (162b) are greater than an area of the others of the plurality of conductive portions (162); the at least one connection substrate (20) comprises a high-side connection substrate (20a) and a low-side connection substrate (20b); the high-side connection substrate (20a) is disposed on the high-side conductive portion (162a); the low-side connection substrate (20b) is disposed on the low-side conductive portion (162b); the at least one power transistor chip group (36) comprises a high-side power transistor chip group (36a) and a low-side power transistor chip group (36b); the high-side power transistor chip group (36a) is disposed on the high-side connection substrate (20a); the low-side power transistor chip group (36b) is disposed on the low-side connection substrate (20b).

5. The power module as claimed in claim 4, wherein both the multilayered metallic connection structure (24) of the high-side connection substrate (20a) and the multilayered metallic connection structure (24) of the low-side connection substrate (20b) comprise a metallic support layer (26); the metallic support layer (26) of the high-side connection substrate (20a) is located on a bottom of the built-in package (22) of the high-side connection substrate (20a), and the metallic support layer (26) of the low-side connection substrate (20b) is located on a bottom of the built-in package (22) of the low-side connection substrate (20b); the high-side power transistor chip group (36a) is electrically connected to the high-side conductive portion (162a) through the metallic support layer (26) of the high-side connection substrate (20a); the low-side power transistor chip group (36b) is electrically connected to the low-side conductive portion (162b) through the metallic support layer (26) of the low-side connection substrate (20b).

6. The power module as claimed in claim 5, wherein the plurality of conductive portions (162) comprise a power conductive portion (162c); the plurality of external connection leads (46) comprise a power lead (46a), a ground lead (46b), and an output lead (46c); an inner end of the power lead (46a) is disposed on the power conductive portion (162c); an inner end of the ground lead (46b) is disposed on the low-side conductive portion (162b); an inner end of the output lead (46c) is disposed on the high-side conductive portion (162a).

7. The power module as claimed in claim 6, wherein the plurality of conductive members (40) comprise at least one first conductive member and at least one second conductive member; the power conductive portion (162c) is connected to a power connection electrode (388) of each of the plurality of power transistor chips (38) of the high-side power transistor chip group (36a) through the at least one first conductive member; the high-side conductive portion (162a) is connected to a power connection electrode (388) of each of the plurality of power transistor chips (38) of the low-side power transistor chip group (36b) through the at least one second conductive member.

8. The power module as claimed in claim 7, wherein the power conductive portion (162c) is located on a side of the high-side conductive portion (162a) and a side of the low-side conductive portion (162b); an extension direction of the at least one first conductive member is perpendicular to an extension direction of the at least one second conductive member.

9. The power module as claimed in claim 7, wherein the at least one first conductive member is at least one first metallic bridge member (422); the at least one second conductive member is at least one second metallic bridge member (424).

10. The power module as claimed in claim 7, wherein both the multilayered metallic connection structure (24) of the high-side connection substrate (20a) and the multilayered metallic connection structure (24) of the low-side connection substrate (20b) include a first top pad (30a), a plurality of second top pads (30b), and an internal circuit (28); the first top pad (30a) and the plurality of second top pads (30b) of the high-side connection substrate (20a) are located on a top of the built-in package (22) of the high-side connection substrate (20a); the first top pad (30a) and the plurality of second top pads (30b) of the low-side connection substrate (20b) are located on a top of the built-in package (22) of the low-side connection substrate (20b); the internal circuit (28) of the high-side connection substrate (20a) is located in an inner portion of the built-in package (22) of the high-side connection substrate (20a) and is connected to the first top pad (30a) and the plurality of second top pads (30b) of the high-side connection substrate (20a); the internal circuit (28) of the low-side connection substrate (20b) is located in an inner portion of the built-in package (22) of the low-side connection substrate (20b) and is connected to the first top pad (30a) and the plurality of second top pads (30b) of the low-side connection substrate (20b); the plurality of second top pads (30b) of the high-side connection substrate (20a) are respectively connected to a control electrode (384) of the plurality of power transistor chips (38) of the high-side power transistor chip group (36a); the plurality of second top pads (30b) of the low-side connection substrate (20b) are respectively connected to a control electrode (384) of the plurality of power transistor chips (38) of the low-side power transistor chip group (36b); the plurality of conductive portions (162) comprise a high-side control conductive portion (162d) and a low-side control conductive portion (162e); the plurality of external connection leads (46) comprise a high-side control lead (46d, 46d') and a low-side control lead (46e, 46e'); an inner end of the high-side control lead (46d, 46d') is disposed on the high-side control conductive portion (162d); an inner end of the low-side control lead (46e, 46e') is disposed on the low-side control conductive portion (162e); the plurality of conductive members (40) comprise a plurality of third conductive members; the high-side control conductive portion (162d) is connected to the first top pad (30a) of the high-side connection substrate (20a) through at least one of the plurality of third conductive members; the low-side control conductive portion (162e) is connected to the first top pad (30a) of the low-side connection substrate (20b) through at least one of the plurality of third conductive members.

11. The power module as claimed in claim 10, wherein the high-side control lead (46d') is a conductive post; the low-side control lead (46e') is a conductive post; the high-side control lead (46d') is vertically disposed on the high-side control conductive portion (162d); the low-side control lead (46e') is vertically disposed on the low-side control conductive portion (162e); the inner end of the high-side control lead (46d') is connected to the high-side control conductive portion (162d); the inner end of the low-side control lead (46e') is connected to the low-side control conductive portion (162e); both an outer end of the high-side control lead (46d') and an outer end of the low-side control lead (46e') extend out of the package (48).

12. The power module as claimed in claim 1, wherein the built-in package (22) of the at least one connection substrate (20) is a polymer.
